# EUROPEAN PATENT SPECIFICATION

(11) **EP 4 190 421 B1**
(45) Date of publication and mention of the grant of the patent: **04.09.2024**
(21) Application number: 21852760.4
(22) Date of filing: 07.07.2021
(51) Int. Cl.: C23C 28/00, C23C 26/00, A63H 17/045

(54) **IRON-COATED PLASTIC MODEL AND METHOD OF MANUFACTURING THE SAME**
EISENBESCHICHTETES KUNSTSTOFFMODELL UND VERFAHREN ZUR HERSTELLUNG DAVON
MODÈLE EN PLASTIQUE REVÊTU DE FER ET SON PROCÉDÉ DE FABRICATION

(30) Priority: 03.08.2020 JP 2020131532; 27.10.2020 JP 2020179333
(43) Date of publication of application: 07.06.2023
(73) Proprietor: Nippon Platec Co., Ltd, Nasushiobara-shi, Tochigi 329-2756 (JP)
(72) Inventor: OIKAWA, Tetsushi, Nasushiobara-shi, Tochigi 329-2756 (JP); ISHIKAWA, Yoshifusa, Nasushiobara-shi, Tochigi 329-2756 (JP)
(74) Representative: Mewburn Ellis LLP
(86) International application number: PCT/JP2021/025603
(87) International publication number: WO 2022/030169

(56) References cited:
- WO-A1-2019/026881
- CN-A- 1 605 866
- DE-U1- 202005 015 711
- JP-A- 2000 160 363
- JP-A- 2000 160 363
- JP-A- 2000 320 673
- JP-A- 2009 078 175
- JP-A- 2010 017 578
- JP-U- S5 784 989
- KR-A- 20040 031 473
- KR-A- 20040 031 473

## Description

### Field of the Invention

The present invention relates to a plastic model that can achieve a realistic surface state by actual iron rust or the like appearing on an iron-coated component surface and a method of manufacturing the plastic model, and a plastic model component thereof and a method of manufacturing the plastic model component.

### BACKGROUND ART

Plastic models have long been sold as plamodel (registered trademark). A variety of such plastic models exists, and representative examples include ships, civilian vessels, sailing boats, and the like, land weapons (tanks, artillery, armored vehicles, and the like), aircraft (fighter planes, passenger planes, helicopters, and the like), rockets, spacecrafts, probes, vehicles (cars, motorcycles, trucks, and the like), railway vehicles, buildings (Himeji Castle, five-storied pagodas, and the like), animation characters, robot characters, science-fiction mechanism, and many more.

These plastic models are assembled using plastic components colored by paint films and the like, and unique ingenuity is exercised to make the color tones more realistic. In the related art, for example, Patent Document 1 proposes a model rail rich in realism with colors close to those of the real thing. In this model rail, a rail made of metal and a sleeper composed of plastic are integrally molded, and the rail is colored with the same color as the brown sleeper or with a rust iron color by corrosion, paint film, plating, or the like. Further, the rail treads are polished to partially expose a metal ground surface, which ensures conductivity between the rail and the wheel.

Further, Patent Document 2 proposes a rail for a railway model rich in reality. In this rail for a railway model, a copper-plated layer is formed on at least a side surface of the rail made of metal, and a layer subjected to chemical conversion treatment is formed on a surface of the copper-plated layer to make the appearance of the rail brown. Then, likening the color tone obtained by the chemical conversion treatment to the rusty tint of iron on a railway rail allows a model-specific expression technique to be realized.

Document WO 2019/026881 A1 relates to a highly-realistic rail for a railway model without degrading conductivity. This track, which is for a railway model and has a metallic rail 3, a copper plated layer 4 on at least a side surface of the rail 3. A chemical conversion treatment layer 5 is formed on the surface of the copper plated layer 4, thereby causing the external appearance of the rail 3 to be brown colored. The chemical conversion treatment layer 5 can be formed, for example, in an antique copper finished layer formed by antique copper finishing, which is a type of chemical conversion treatment. The color obtained by the chemical conversion treatment represented by the antique copper finishing is considered to be the color of corroded iron in railway rails, and this treatment is thus employed as a model representation method.

### PRIOR ART DOCUMENTS

### Patent Documents

Patent Document 1: Japanese Unexamined Utility Model Application Publication No. S49-79395
Patent Document 2: Japanese Laid-Open Patent Application Publication No. 2019-25208

### SUMMARY OF THE INVENTION

### Problems to be Solved by the Invention

Some enthusiasts of military-related plastic models, such as military weapons, tanks, and battleships have devised paint films to create the feel of a metal material. In response to such demand, products for creating the feel of a metal material as in the related art described above (for example, paints, surface adhesives, and the like) are sold. However, these are merely paint films, chemical conversion treatments, and the like, and the surface state differs from that of real material, which is inferior to reality, looks cheap at a close distance, and cannot satisfy enthusiasts.

Further, enthusiasts desire to increase the reality such as in the real thing by covering the surface with red rust. In response, until now, red powder has been sprinkled on and adhered to the surface, or the like. However, the surface state differs from that of real material, which is inferior to reality. For enthusiasts, if the model can be changed over time by the progression of rust or the like just like the real thing, intentionally scratched to generate rust, and removed of the existing rust and scratched in a new location to generate new rust, the fun of being closer to the real thing increases.

The present invention has been made to solve the above-described problems, and an object thereof is to provide a plastic model that can achieve a realistic surface state by actual iron rust or the like appearing on an iron-coated component surface and a method of manufacturing the plastic model, and a plastic model component thereof and a method of manufacturing the plastic model component.

### Means for Solving the Problems

(1) A plastic model according to the present invention is a plastic model assembled by components, some or all components include a base material and at least an iron-coated layer provided on the base material. The plastic model includes one or two or more areas selected from states of (a) being provided with a paint film on a portion where rust is generated on the iron-coated layer, (b) not being provided with a paint film on a portion where rust is generated on the iron-coated layer, (c) being provided with a paint film on a portion where rust is not generated on the iron-coated layer, and (d) not being provided with a paint film on a portion where rust is not generated on the iron-coated layer.

According to this invention, at least an iron-coated layer is provided on the base material, making it possible to make the material have the same metal feel or iron material feel as that in the real material in terms of appearance and texture, and make the surface realistic beyond the realm of a model. As a result, it is possible to make the plastic model look like the real thing at a close distance as well, and make enthusiasts very satisfied. Further, rust can be generated or advanced as in the real thing by scraping off the paint film to expose the iron-coated layer, scratching the iron-coated layer, or the like. As a result, by causing changes over time or intentionally adding scratches to generate rust, it is possible to make it look as if changes occurred over time, and have each enthusiast create an original model. Furthermore, it is also possible to remove the existing rust and scratch new locations to generate new rust and thus change the model to have an appearance different from the previous one, achieving a plastic model that increases a great deal of fun for the enthusiast. It should be noted that "some or all" means that the plastic model may be assembled using some components provided with the iron-coated layer, or the plastic model may be assembled with all components provided with the iron-coated layer.

Further, according to this invention, it is possible to provide the various portions in (a) to (d) as desired, and thus change the state of rust for each portion of the model as desired. Furthermore, a portion where the progression of rust is stopped and a portion where the progression of rust is continued can be made to coexist. As a result, each enthusiast can create an original model.

Further according to the present invention, the iron-coated layer is provided directly on the base material, the iron-coated layer is provided between the base material and the paint film, the iron-coated layer is provided as an outermost surface layer on another layer provided as necessary on the base material, the iron-coated layer is provided between another layer provided as necessary on the base material and the paint film, or the paint film is provided between the base material and the iron-coated layer. According to this invention, it is possible to achieve components in which the iron-coated layer is provided on the base material in various modes, and thus provide a lineup of various types of components and have each enthusiast create an original model through various innovations.

Further according to the present invention, the iron-coated layer is a pure iron-coated layer or an iron alloy-coated layer. Examples of the iron alloy-coated layer include an FeCr alloy-coated layer, an FeNi alloy-coated layer, an FeNiCr alloy-coated layer, an FeC alloy-coated layer, and the like. It should be noted that the iron-coated layer may include one or two or more elements selected from P, N, W, and Mo.

Further according to the present invention, the iron-coated layer may contain a dispersing material. It should be noted that examples of the dispersing material include hard particles, magnetic particles, colored particles, roughened particles, and the like.

Further according to the present invention, the iron-coated layer is deposited by a wet deposition method, a physical vapor deposition (PVD) method, or a chemical vapor deposition (CVD) method.

Further according to the present invention, a portion where rust is generated on the iron-coated layer and a portion where rust is not generated on the iron-coated layer coexist. According to this invention, these portions coexist, making it possible to change the state of rust for each portion of the model as desired. As a result, each enthusiast can create an original model.

Further according to the present invention, the other layer is a base treatment layer, a base layer, or a metal layer.

(2) A plastic model component according to the present invention defined in claim 8 is a plastic model component used as some or all components of the plastic model according to the above-described present invention, comprising a base material, and at least an iron-coated layer provided on the base material. The plastic model component includes one or two or more areas selected from states of being provided with a paint film on a portion where rust is generated on the iron-coated layer, not being provided with a paint film on a portion where rust is generated on the iron-coated layer, being provided with a paint film on a portion where rust is not generated on the iron-coated layer, and not being provided with a paint film on a portion where rust is not generated on the iron-coated layer.

Further according to the present invention, the area is an area capable of changing over time by, in a case in which the iron-coated layer is exposed on the surface, causing natural corrosion in the iron-coated layer or increasing rust by placement in an oxidation environment, or, in a case in which the paint film is provided on the iron-coated layer, causing or increasing rust as in the real thing by a process of scraping off the paint film to expose the iron-coated layer or a process of scratching the paint film.

(3) A method of manufacturing a plastic model according to the present invention is a method of manufacturing the plastic model according to the above-described present invention, comprising at least forming an iron-coated layer on a prepared base material to fabricate an iron-coated layer forming component, and, as necessary, applying another treatment to the iron-coated layer forming component to fabricate a plastic model component, the plastic model being assembled using the plastic model component thus fabricated as some or all components.

The plastic model thus assembled includes one or two or more areas selected from states of being provided with a paint film on a portion where rust is generated on the iron-coated layer, not being provided with a paint film on a portion where rust is generated on the iron-coated layer, being provided with a paint film on a portion where rust is not generated on the iron-coated layer, and not being provided with a paint film on a portion where rust is not generated on the iron-coated layer.

(4) A method of manufacturing a plastic model component according to the present invention defined in claim 10 is a method of manufacturing some or all components of the plastic model according to the above-described present invention, the method comprising at least forming an iron-coated layer on a prepared base material.

The plastic model component thus manufactured includes one or two or more areas selected from states of being provided with a paint film on a portion where rust is generated on the iron-coated layer, not being provided with a paint film on a portion where rust is generated on the iron-coated layer, being provided with a paint film on a portion where rust is not generated on the iron-coated layer, and not being provided with a paint film on a portion where rust is not generated on the iron-coated layer.

Further according to the present invention, the iron-coated layer is deposited by varying deposition conditions selected from a deposition time, a deposition temperature, a deposition composition, and the like. According to this invention, the iron-coated layer is deposited by varying the deposition conditions, making it possible to change a color tone, a degree of corrosion occurrence, a degree of corrosion progression, a color tone of a corrosion product, a hardness, and the like of the obtained iron-coated layer as desired.

Further according to the present invention, the iron-coated layer is preferably provided on a treated base or on a base layer. According to this invention, it is possible to improve an adhesion or the like of the iron-coated layer by providing the iron-coated layer on the treated base or on the base layer.

### Effect of the Invention

According to the present invention, it is possible to provide a plastic model that can achieve a realistic surface state by actual iron rust or the like appearing on an iron-coated component surface and a method of manufacturing the plastic model, and a plastic model component thereof and a method of manufacturing the plastic model component.

### BRIEF DESCRIPTION OF THE DRAWINGS

Fig. 1 is a cross-sectional configuration view illustrating an example of a plastic model component according to the present invention.
Figs. 2A to 2C are cross-sectional configuration views illustrating other examples of the plastic model component according to the present invention.
Figs. 3A to 3C are cross-sectional configuration views illustrating yet other examples of the plastic model component according to the present invention.
Figs. 4A to 4C are photographs showing an example of the plastic model according to the present invention.
Figs. 5A to 5C are photographs showing another example of the plastic model according to the present invention.
Fig. 6A is a photograph of a case in which various paint films were provided on an iron-coated layer and subsequently partially removed to expose the iron-coated layer, and Fig. 6B is an arrangement diagram illustrating positions of each paint film and the portions where the paint film was removed.
Fig. 7A is a surface photograph with the iron-coated layer provided as is, and Fig. 7B is a surface photograph after the iron-coated layer was provided and subsequently polished with a liquid metal polisher.
Fig. 8A is a surface photograph after a copper-plated layer was provided on a base material, and Fig. 8B is a surface photograph after a copper-plated layer and an iron-coated layer were sequentially provided on a base material.
Fig. 9A shows a case in which, in the plastic model, rust was generated on the iron-coated layer and, without being coated with clear paint, left in that state, and Fig. 9B shows a case in which rust was generated on the iron-coated layer and was subsequently coated with clear paint and left in that state.
Figs. 10A to 10C show first corrosion accelerating test results of the iron-coated layer.
Fig. 11 is a continuation of the first corrosion accelerating test results shown in Figs. 10A to 10C.
Fig. 12 shows a second corrosion accelerating test result of the iron-coated layer.

### Embodiments of the Invention

A plastic model, a plastic model component, and manufacturing methods thereof according to the present invention will now be described with reference to the drawings. The present invention includes inventions having the same technical idea as that in the following embodiments and forms described in the drawings, and the technical scope of the present invention is not limited to only the descriptions of the embodiments and the descriptions of the drawings. It should be noted that, hereinafter, the plastic model component according to the present invention may be simply referred to as "model component."

### [Plastic Model and Model Component]

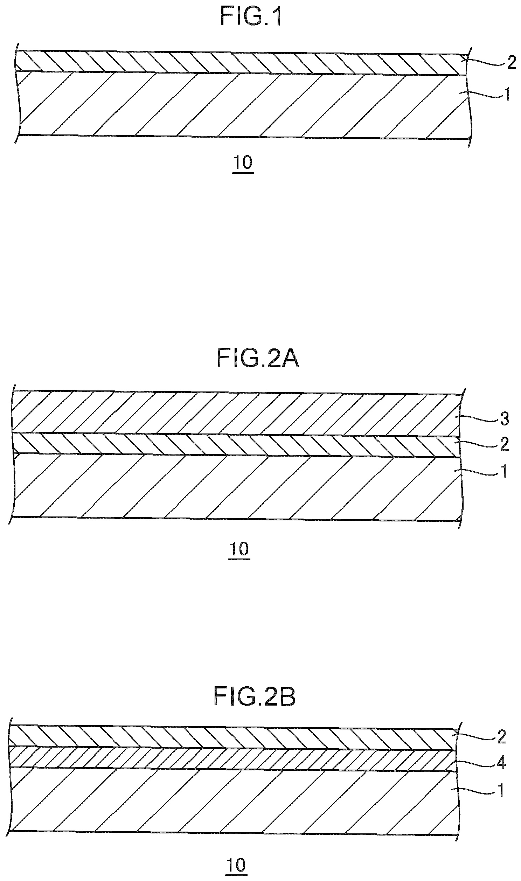

A plastic model 20 according to the present invention, as illustrated in Fig. 1 to Fig. 3C, is assembled using a component 10 including a base material 1 and at least an iron-coated layer 2 provided on the base material 1 as some or all components.

In such a plastic model 20, at least the iron-coated layer 2 is provided on the base material 1, making it possible to make the material have the same metal feel or iron material feel as that in the real material in terms of appearance and texture, and make the surface realistic beyond the realm of a model. As a result, it is possible to make the plastic model look like the real thing at a close distance as well, and make enthusiasts very satisfied. Further, rust can be generated or advanced as in the real thing by scraping off the paint film to expose the iron-coated layer 2, scratching the iron-coated layer 2, or the like. As a result, by causing changes over time or intentionally adding scratches to generate rust, it is possible to make it look as if changes occurred over time, and have each enthusiast create an original model. Furthermore, it is also possible to remove the existing rust and scratch new locations to generate new rust, and thus change the model to have an appearance different from the previous one, achieving the plastic model 20 that increases a great deal of fun for the enthusiast.

It should be noted that "at least" means that the iron-coated layer 2 is always provided on the base material. "Including" means that configuration other than the base material 1 and the iron-coated layer 2 may be provided as desired. "Some or all" means that the plastic model 20 may be assembled using some components 10 provided with the iron-coated layer 2, or the plastic model 20 may be assembled with all components provided with the iron-coated layer 2.

In the following, each constituent element will be described in detail.

### (Base material)

The base material 1, as illustrated in Fig. 1 and the like, constitutes the model component 10 and is the foundation on which the iron-coated layer 2 is provided. A material of the base material 1 is not particularly limited as long as a material conventionally used, and general examples include plastic base materials (also referred to as resin base materials). Examples of a plastic base material include polystyrene (PS), acrylonitrile butadiene styrene (ABS) resin, a polyolefin such as polyethylene (PE) and polypropylene (PP), vinyl chloride, acrylic resin, and the like. It should be noted that the material may be other than a plastic base material and, for example, may be a base material made of a metal (aluminum, molybdenum, stainless steel, copper, or the like), may be a base material made of a ceramic (zirconia, alumina, or the like), or may be a base material composed of any other material.

A shape of the base material 1 is determined by the portion corresponding to the component constituting the plastic model 20 to be constituted by the component. Such a shape, in the case of a general plastic base material, can be obtained by various molding methods.

### (Iron-coated layer)

The iron-coated layer 2, as illustrated in Fig. 1 to Fig. 3C, constitutes the model component 10 and is provided on the base material 1. The iron-coated layer 2 may be provided directly on the base material 1 without another layer interposed therebetween (refer to Fig. 1), may be provided between the base material 1 and a paint film 3 (refer to Fig. 2A), may be provided as an outermost surface layer on another layer 4 provided as necessary on the base material 1 (refer to Fig. 2B), or may be provided between the other layer 4 provided as necessary on the base material 1 and the paint film 3 (refer to Fig. 2C). It should be noted that Figs. 2A to 2C illustrate cross-sectional forms in which a film such as the iron-coated layer 2 is provided on one side of the base material 1, but the film may be provided symmetrically on both sides of the base material 1. Providing each layer symmetrically on both sides eliminates the need for masking, resulting in the advantage of superior productivity.

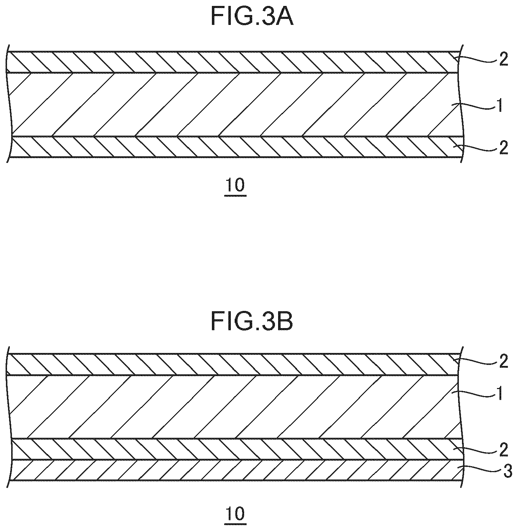

Figs. 3A to 3C are cross-sectional views illustrating yet other examples. Fig. 3A illustrates a cross-sectional form in which the iron-coated layer 2 is directly provided on both sides of the base material 1. This way, the iron-coated layer 2 can be provided on both sides of the base material at the same time. Fig. 3B illustrates a cross-sectional form in which the iron-coated layer 2 is directly provided on one side of the base material 1, and the iron-coated layer 2 is directly provided on the other side as well with the paint film 3 further provided thereon. This way, it is possible to generate iron rust on the iron-coated layer 2 of the outermost surface of one side, and prevent generation of iron rust and maintain the iron surface as is on the iron-coated layer 2 of the other side provided with the paint film 3 unless intentionally scratched. Fig. 3C illustrates a cross-sectional form in which the iron-coated layer 2 is directly provided on one side of the base material 1, and the other layer 4 is directly provided on the other side. This way, the other layer 4 provided on the other side is a copper layer or a nickel layer, for example, making it possible to realize a surface with another metal color tone. By applying the forms represented in Figs. 2A to 2C, Figs. 3A to 3C, or the like, it is possible to provide components in which the iron-coated layer 2 is provided on the base material 1 in various modes. As a result, it is possible to provide a lineup of various types of the model component 10 and have each enthusiast create the original plastic model 20 through various innovations.

The iron-coated layer 2 is, specifically, a pure iron-coated layer or an iron alloy-coated layer. A pure iron-coated layer refers literally to one having a high purity composition of iron (99.9% or higher), and an iron alloy-coated layer refers to one obtained by alloying with other elements. Examples of the other elements include Cr, Ni, C, Si, and the like, and examples of the iron alloy-coated layers include a layer containing one or two or more of these elements, such as an FeCr alloy-coated layer, an FeNi alloy-coated layer, an FeNiCr alloy-coated layer, an FeC alloy-coated layer, and an FeSi alloy-coated layer. The content of Cr, Ni, C, Si, or the like is not particularly limited, and a desired amount can be contained for film performance corresponding to the content.

The iron-coated layer 2 may include one or two or more elements selected from P, N, W, and Mo, corresponding to formulating purpose. These P, N, W, Mo, and the like may be further included as necessary in addition to the alloy element described above. These elements are included in the iron-coated layer 2 in various forms, such as alloyed or combined with Fe. The content of the element is not particularly limited, and a desired amount can be contained for film performance corresponding to the content.

The iron-coated layer 2 may include a dispersing material. The dispersing material is not particularly limited, and examples include hard particles, magnetic particles, colored particles, roughened particles, and the like. Hard particles are used for the purpose of hardening or strengthening the iron-coated layer 2, and examples include diamond, cBN, and the like. Magnetic particles are used for the purpose of imparting further magnetic properties to the iron-coated layer 2, and examples include soft magnetic material powders such as Fe-Si-based alloys, Fe-Ni-based alloys, and Fe-Co-based alloys, ferrite powders, and the like. Colored particles are used for the purpose of changing the color tone of the iron-coated layer 2, and examples include inorganic particles such as iron (III) oxide particles, silica particles, and alumina particles, plastic particles colored with a colorant, and the like. Roughened particles are used for the purpose of roughening the surface of the iron-coated layer 2 to give it a matte feel and, for example, each of the particles described above can be used as the roughened particles. It should be noted that the content of the dispersing material is not particularly limited, and a desired amount can be contained for film performance corresponding to the content. When the dispersing material is to be contained, a particle size of the dispersing material is also selected as desired, and a dispersing material of a particle size corresponding to purpose is contained.

### (Deposition of iron-coated layer)

The iron-coated layer 2 is deposited by a wet deposition method, a physical vapor deposition (PVD) method, or a chemical vapor deposition (CVD) method. Wet deposition methods include electroplating, electroless plating, and the like, PVD methods include vacuum deposition, sputtering, ion plating, and the like, and CVD methods are chemical vapor deposition methods. The iron-coated layer 2 is deposited by one of these deposition methods on the basis of the characteristics of each of the methods. The properties of the obtained iron-coated layer 2 can be controlled to desired properties by depositing while varying deposition conditions selected from a deposition time, a deposition temperature, a deposition composition, and the like.

An example of depositing the iron-coated layer 2 by electroplating will be described below. In the case of deposition by electroplating, the base material 1 and other layers provided on the base material 1 must be conductive, and therefore the base material 1 having conductivity (base material made of metal) and a base film having conductivity must be provided in advance. Examples of an iron plating solution used include an iron sulfate plating solution, an iron chloride plating solution, an iron plating solution including iron sulfate and iron chloride, an iron sulfamate plating solution, and the like. Further, various supporting electrolytes and additives (leveling agents, dispersants, stress relaxing agents, surfactants, and the like) can be contained as necessary. Examples of plating conditions include current density, temperature, pH, and the like, and these conditions can be set as desired. Furthermore, the plating means may be direct current plating or may be pulse plating. A thickness of the iron-plated layer is not particularly limited and can be set as desired depending on current density, electrolysis time, and the like, and normally is preferably about 5 to 20 µm. It should be noted that the iron-plated layer can also contain carbon and, in this case, the layer preferably includes at least one type or two or more types of carboxylic acids and salts thereof, such as formic acid, acetic acid, citric acid, oxalic acid, tartaric acid, malic acid, succinic acid, and ascorbic acid. Fe3O4 (magnetite), which is an oxide layer, can also be formed on the outermost surface of the iron-plated layer. With such an oxide layer provided, there is the advantage of improving performance, such as adhesion inhibiting effects, hardening, improved wear resistance, and improved grindstone retention. This oxide layer is not essential, and thus need not be provided. The oxide layer is provided by means of anodic electrolysis, heat treatment, and black dyeing treatment of the iron-plated layer. It should be noted that, although it is not very common to form the iron-coated layer 2 by electroless plating, electroless plating may be applied in the same way as the electroplating described above.

Next, an example of depositing the iron-coated layer 2 by the PVD method will be described. Representative PVD methods include vacuum deposition, sputtering, ion plating, and the like, and can be deposited using known means corresponding to each deposition method. It should be noted that, although these methods can impart various compositions and film properties that differ from those of wet deposition, wet deposition has higher productivity and is therefore desirably adopted based on a comprehensive assessment.

It should be noted that, in the iron-coated layer 2, the content of alloy elements, the content of other elements, the content of dispersing materials, and the like can be controlled by the deposition means, the amounts of the elements and dispersing materials supplied during deposition, and the deposition conditions.

### (Paint film)

The paint film 3 is provided as desired, as necessary. The paint film 3 may be fully or partially provided on both the front and back sides of the model component 10, or may be fully or partially provided on one side, as exemplified in Figs. 2A to 2C and Figs. 3A to 3C. The paint film 3 may be provided on the iron-coated layer 2 or may be provided between the base material 1 and the iron-coated layer 2. It should be noted that, in a case in which the iron-coated layer 2 is provided on the paint film 3, it is preferable to perform pretreatment corresponding to the deposition means as appropriate so that the iron-coated layer 2 is readily deposited on the paint film 3.

Examples of the paint film 3 include commonly used lacquer-type paints, water-based acrylic paints, and enamel paints. These paints are formulated with additives, colorants, and the like, as desired. A viscosity can also be adjusted by formulating a dilution solvent corresponding to the paint.

The "other layer 4" may be a base treatment layer or a base layer, or may be another metal layer. The base treatment layer includes a surface of the base material 1 after having been treated for a specific purpose in correspondence with the material of the base material 1, and examples of such treatment include a smoothing treatment, a roughening treatment, a chemical conversion treatment, an impregnating treatment, an oxidizing treatment, a nitriding treatment, and the like. The base layer is another layer provided on the surface of the base material 1 for a specific purpose, and examples of the deposition method include wet plating such as electroplating and electroless plating, PVD such as vacuum deposition, sputtering, and ion plating, CVD, and the like. Specific examples include base plating with nickel, copper, or the like, metal vapor deposition layers with aluminum and the like. Such a base treatment layer or base layer is provided for the purpose of imparting gloss or non-gloss (matte) to the iron-coated layer 2, provided for improving the adhesion of the iron-coated layer 2, or provided for stress relaxation after the iron-coated layer 2 is deposited, and is not limited to these representative examples.

The other layer 4 may be a metal layer. The metal layer in this case is not applied for the same purpose as that of the base layer, and examples include a metal layer composed of Cu, Ni, Cr, or an alloy thereof, each of which exhibits a color tone different from that of the iron-coated layer 2.

The plastic model 20 is constituted by many model components 10. The model components 10 of the present invention need only be one or two or more components illustrated in Figs. 1 to 3C, may all be the same type of the model component 10, or may be various types of the model component 10 corresponding to the area of the plastic model 20, for example. With the plastic model 20 formed with various parts, a realistic surface state can be achieved by iron rust or the like in the areas where the model component 10 according to the present invention is applied, and general plastic components may be applied as is to areas where such a surface state is not particularly required.

### (Coexistence of various states)

The plastic model 20 according to the present invention may be a model in which various states are made to coexist. Specifically, as described in the experiment examples mentioned below, a portion where rust is generated on the iron-coated layer 2 and a portion where rust is not generated on the iron-coated layer 2 may be made to coexist. By making such different portions coexist, it is possible to change the state of the rust as desired for each portion of the plastic model 20. As a result, each enthusiast can create an original model.

Further, the plastic model 20 may include one or two or more areas selected from a location in which the paint film 3 is provided on a portion where rust is generated on the iron-coated layer 2, a location in which the paint film 3 is not provided on a portion where rust is generated on the iron-coated layer 2, a location in which the paint film 3 is provided on a portion where rust is not generated on the iron-coated layer 2, and a location in which the paint film 3 is not provided on a portion where rust is not generated on the iron-coated layer 2. By thus providing various portions as desired, it is possible to change the state of the rust as desired for each portion of the plastic model 20. Furthermore, a portion where the progression of rust is stopped and a portion where the progression of rust is continued can be made to coexist. As a result, each enthusiast can create an original model.

### (Manufacturing method)

A method of manufacturing the plastic model 20 according to the present invention includes at least forming the iron-coated layer 2 on the prepared base material 1 to fabricate an iron-coated layer forming component and, as necessary, applying another treatment to the iron-coated layer forming component to fabricate the plastic model component 10, the plastic model 20 being assembled using the plastic model component 10 thus fabricated as some or all components.

The plastic model component 10 is used as some or all components of the plastic model 20, and includes the base material 1 and at least the iron-coated layer 2 provided on the base material 1, as already explained. A method of manufacturing this plastic model component 10 includes at least forming the iron-coated layer 2 on the prepared base material 1. As explained in detail in the explanatory section of the above-described "iron-coated layer," the iron-coated layer 2 is deposited by varying the deposition conditions selected from the deposition time, the deposition temperature, the deposition composition, and the like, making it possible to change the color tone, the degree of corrosion occurrence, the degree of corrosion progression, the color tone of corrosion products, the hardness, and the like, as desired.

### (Appearance of model)

The plastic model 20 is provided with the iron-coated layer 2 on the surface thereof or below the paint film 3. When the iron-coated layer 2 is provided on the surface, unlike a metallic paint film, it is possible to make the material have the same metal feel or iron material feel as that in the real material in terms of appearance and texture, and make a realistic surface beyond the realm of a model. Further, the iron-coated layer 2 is exposed on the outer surface, making it possible to cause natural corrosion. Further, the corrosion of the iron-coated layer 2 can be advanced by dripping salt water thereon or by placing the model in an oxidation environment. Further, for corrosion that has progressed, it is also possible to stop or suppress the progression of the corrosion by applying clear paint. Furthermore, by intentionally adding scratches such as, for example, forming scratches on a model of a tank or the like and causing the scratched portion to corrode, it is possible to produce a reality such as in the real thing and bring out the originality of the enthusiast. In addition, by providing a lineup of model components 10 obtained by changing the composition of the iron-coated layer 2 as desired, it is also possible to make the outer surface not limited to the surface with red rust alone.

Further, the surface of the iron-coated layer 2 may be polished to a mirror finish. The degree of the polished finish is also not particularly limited, and any polished surface can be achieved. It should be noted that the polishing can be applied even in a case in which a metal layer is provided as the other layer 4.

It should be noted that, in a case in which the iron-coated layer 2 is provided below the paint film, the iron-coated layer 2 remains as is without changing, but can be caused to corrode by partially scraping off or scratching the paint film 3. Further, by forming the iron-coated layer 2 somewhat thicker, it is also possible to scrape off and restore a rusted location, and cause the location to corrode again to make the state different from the previous one.

The present invention makes it possible to make the plastic model look like the real thing at a close distance as well, and make enthusiasts very satisfied. The plastic model component 10 according to the present invention is most likely sold normally as a product in a "plastic model set" together with other model components for fabricating the plastic model 20 (plastic components without the iron-coated layer 2), but may be a product sold in bulk as the model component 10 including the iron-coated layer 2.

### Examples

The present invention will be described in more detail below by experiments. The present invention is not limited to the content obtained in the following experiments.

### [Sample 1]

As the base material 1, a plastic model component composed of degreased polystyrene resin was used. A general iron sulfate plating solution (including ferrous sulfate and citric acid monohydrate) for forming a pure iron plating film was used as a plating solution to form the iron-coated layer 2 having a thickness of approximately 10 µm on the base material 1 (refer to Fig. 1).

### [Sample 2]

As the base material 1, a plastic model component composed of degreased polystyrene resin was used. An iron sulfate plating solution (including ferrous sulfate, citric acid monohydrate, and L-ascorbic acid) for forming an FeC alloy plating film was used as a plating solution to form the FeC alloy-coated layer 2 containing approximately 1 mass% carbon and having a thickness of approximately 5 µm on the base material 1.

### [Sample 3]

As the base material 1, a plastic model component composed of degreased polystyrene resin was used. An iron sulfate - iron chloride plating solution (including ferrous sulfate, citric acid monohydrate, and L-ascorbic acid) for forming an FeC alloy plating film was used as a plating solution to form the FeC alloy-coated layer 2 containing approximately 0.1 mass% carbon and having a thickness of approximately 10 µm on the base material 1.

### [Sample 4]

As the base material 1, a plastic model component composed of degreased polystyrene resin was used. A dispersion plating solution containing industrial diamond as a dispersant in an iron sulfate - iron chloride plating solution (including ferrous sulfate, iron chloride, citric acid monohydrate, and L-ascorbic acid) for forming an FeC alloy plating film was used as a plating solution to form the FeC alloy-coated layer 2 having a diamond volume ratio of 12.5%, containing approximately 1 mass% carbon, and having a thickness of approximately 5 µm on the base material 1.

### [Samples 5 to 8]

For Sample 5, the paint film 3 was provided on the iron-coated layer 2 of Sample 1 using a water-based acrylic paint (refer to Fig. 2A). For Sample 6, the iron-coated layer 2 was provided on the base material surface of Sample 1 on a side opposite to the side provided with the iron-coated layer 2 (refer to Fig. 3A). For Sample 7, the iron-coated layer 2 was provided on the base material surface of Sample 1 on a side opposite to the side provided with the iron-coated layer 2, and the paint film 3 was further provided thereon using a water-based acrylic paint (refer to Fig. 3B). For Sample 8, a copper-plated layer was provided as the other layer 4 on the base material surface of Sample 1 on a side opposite to the side provided with the iron-coated layer 2 (refer to Fig. 3C).

### [Experiment Example 1]

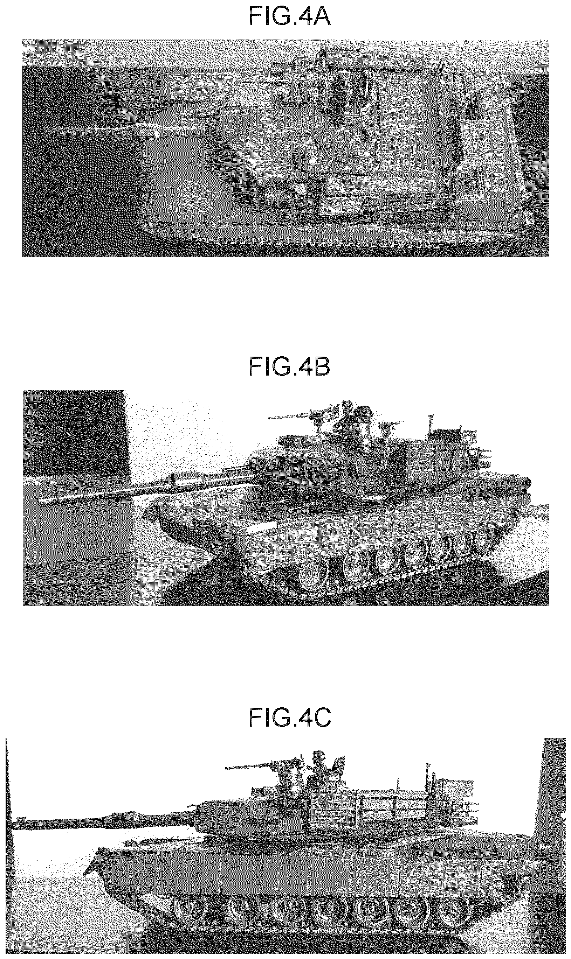

The plastic model 20, which is a tank model, was fabricated using the model component 10 of Sample 1. Photographs thereof are shown in Figs. 4A to 4C. On the plastic model 20 shown in Figs. 4A to 4C, a faint iron rust was formed over the entirety by natural corrosion after fabrication of the model components 10, making it possible to achieve a realistic surface state by actual iron rust.

### [Experiment Example 2]

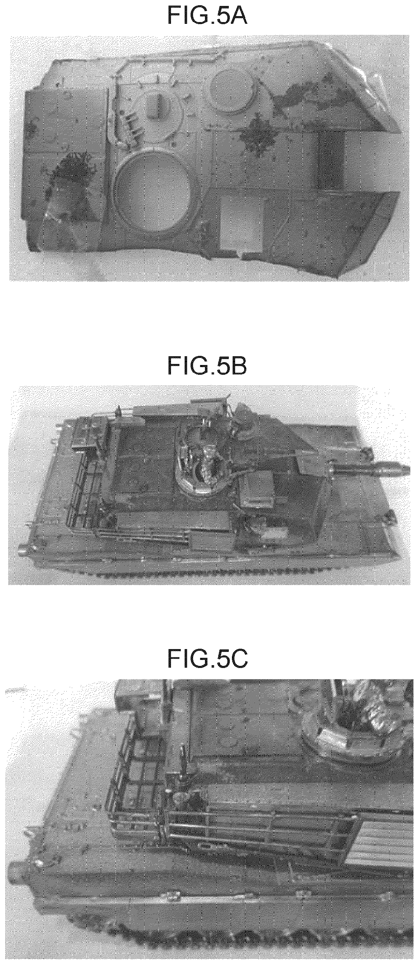

The plastic model 20, which is a tank model, was fabricated using the model component 10 of Sample 1. Photographs thereof are shown in Figs. 5A to 5C. It should be noted that the plastic model 20 shown in Fig. 5A is a form obtained by partially dripping a saline solution immediately after fabrication to intentionally generate iron rust. The plastic model 20 shown in Fig. 5B is a form obtained 6 months after fabrication, and Fig. 5C is an enlarged view thereof.

### [Experiment Example 3]

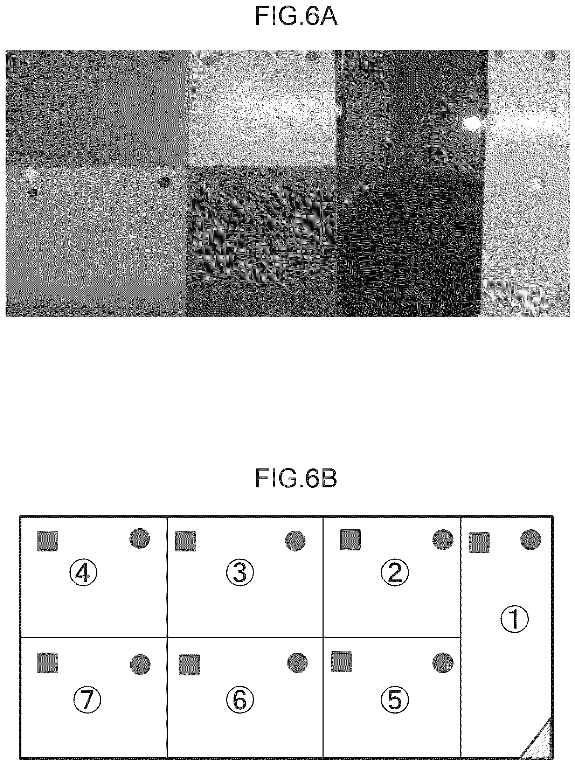

A test was conducted by providing various paint films on the iron-coated layer and subsequently partially removing the paint film to expose the iron-coated layer. Fig. 6A is a photograph of a case in which various paint films 3 were provided on the iron-coated layer 2 and subsequently partially removed to expose the iron-coated layer 2, and Fig. 6B is an arrangement diagram illustrating positions of each paint film and the portions where the paint film was removed. The sample used was obtained by using a transparent polystyrene board having a thickness of 1 mm as the base material, providing electroless copper plating (Rochelle salt bath) thereon, providing the same FeC alloy-coated layer as in Sample 2 thereon, and providing various paint films thereon.

In Fig. 6B, number 1 indicates a sprayed paint film having a milk tea beige color obtained by using ZGF Milk Tea Beige MS-41 from Musashi Holts Co., Ltd. Number 2 indicates a sprayed paint film having a transparent clear color obtained by using Transparent Clear from Nippe Home Products Co., Ltd. Number 3 indicates a brushed paint film having a milk tea beige color obtained by using ZGF Milk Tea Beige MS-41 from Musashi Holts Co., Ltd. Number 4 indicates a sprayed paint film having a burnt iron color obtained by using H-76 Burnt Iron from GSI Creos Corporation. Number 5 indicates the iron-coated layer as is without a paint film. Number 6 indicates a sprayed paint film having an olive gray color obtained by using H-48 Olive Gray (Field Gray 2) from GSI Creos Corporation. Number 7 indicates a sprayed paint film having a dark yellow color obtained by using 39 Dark Yellow from GSI Creos Corporation. It should be noted that "O" portions are portions where the paint film was provided and then removed by a solvent (acetone), "□" portions are portions where the paint film was provided and then removed by polishing (water proof abrasive paper, #320), and "△" portions are the polystyrene base material without a paint film.

As shown in Figs. 6A and 6B, paint films having various colors can be provided, and each paint film can be removed by a solvent or polishing to partially expose the iron-coated layer. As a result, it is possible to provide various portions as desired, and cause and further advance corrosion in a portion in which the iron-coated layer is exposed, in particular.

### [Experiment Example 4]

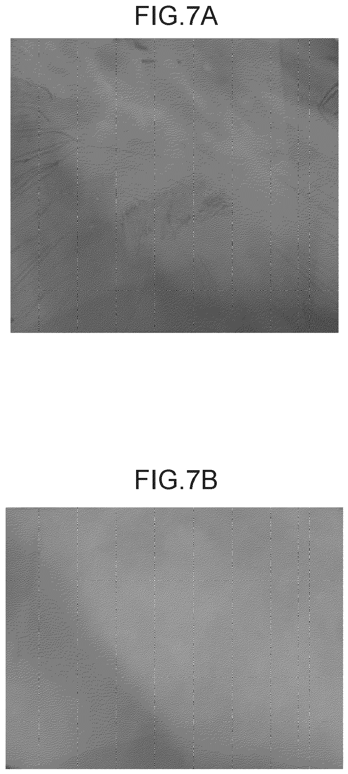

After the iron-coated layer was provided, the surface of the iron-coated layer was polished. Fig. 7A is a surface photograph with the iron-coated layer provided as is, and Fig. 7B is a surface photograph after the iron-coated layer was provided and subsequently polished with a liquid metal polisher. The sample used was obtained by using a transparent polystyrene board having a thickness of 1 mm as the base material, providing electroless copper plating (Rochelle salt bath) thereon, and providing the same FeC alloy-coated layer as in Sample 2 thereon. Polishing was carried out with a rag using a liquid metal polisher (20% alumina mineral abrasive) from Nihon Maryo Kogyo Co., Ltd.

The surface of the iron-coated layer after polishing was glossy. Such polishing can form various surface states, and cause or further advance corrosion on the surface.

### [Experiment Example 5]

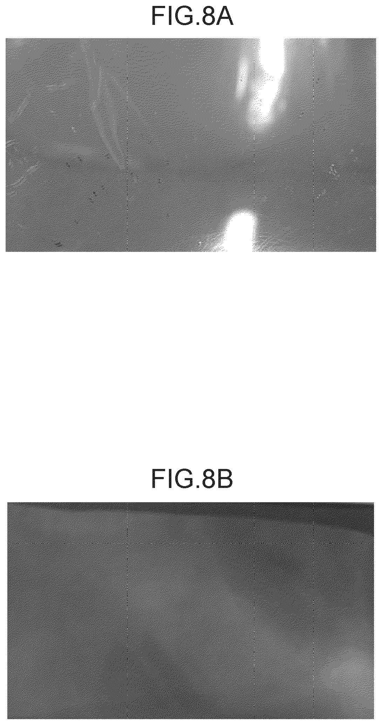

Fig. 8A is a surface photograph after a copper-plated layer was provided on a base material, and Fig. 8B is a surface photograph after a copper-plated layer and an iron-coated layer were sequentially provided on a base material. The sample used was obtained by using a transparent polystyrene board having a thickness of 1 mm as the base material, providing electroless copper plating (Rochelle salt bath) thereon, and providing the same FeC alloy-coated layer as in Sample 2 thereon.

As shown in Figs. 8A and 8B, in a case in which the iron-coated layer is to be provided on a non-conductive base material, by providing the copper-plated layer by electroless plating after masking the entire surface or the predetermined region on the base material, or the like, the iron-coated layer can also be provided on the entire surface or in a predetermined region (region where the copper-plated layer is provided).

### [Experiment Example 6]

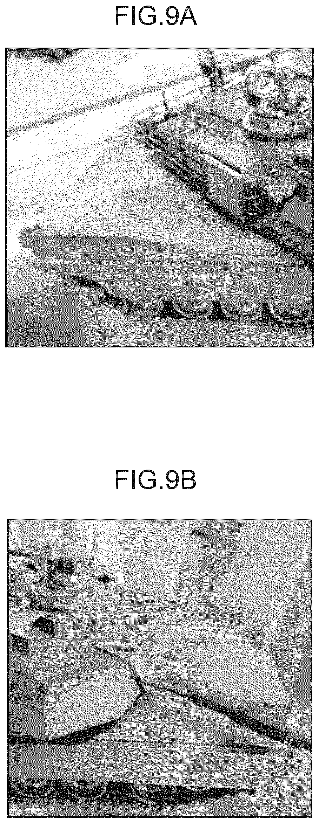

Fig. 9A shows a case in which rust was generated on the iron-coated layer and, without being coated with clear paint, left in that state, and Fig. 9B shows a case in which rust was generated on the iron-coated layer and was subsequently coated with clear paint and left in that state. The sample used was obtained by using a transparent polystyrene board having a thickness of 1 mm as the base material, providing electroless copper plating (Rochelle salt bath) thereon, and providing the same FeC alloy-coated layer as in Sample 2 thereon.

As shown in Figs. 9A and 9B, by applying clear paint in a preferred rust state, it is possible to suppress further erosion of the rust. It should be noted that, when the clear paint was applied, a slight gloss appeared.

### [Experiment Example 7]

A first corrosion accelerating test was conducted. The sample used was obtained by using a transparent polystyrene board having a thickness of 1 mm as the base material, providing electroless copper plating (Rochelle salt bath) thereon, and providing the same FeC alloy-coated layer as in Sample 2 thereon. The test was conducted in an environment having a room temperature of 25°C to 30°C and a humidity of 50% to 60%.

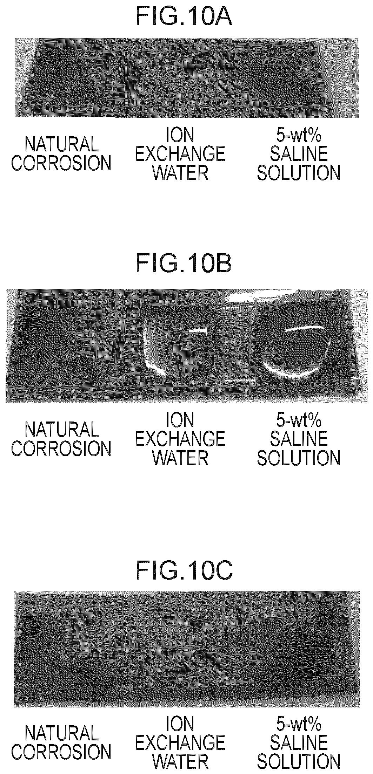

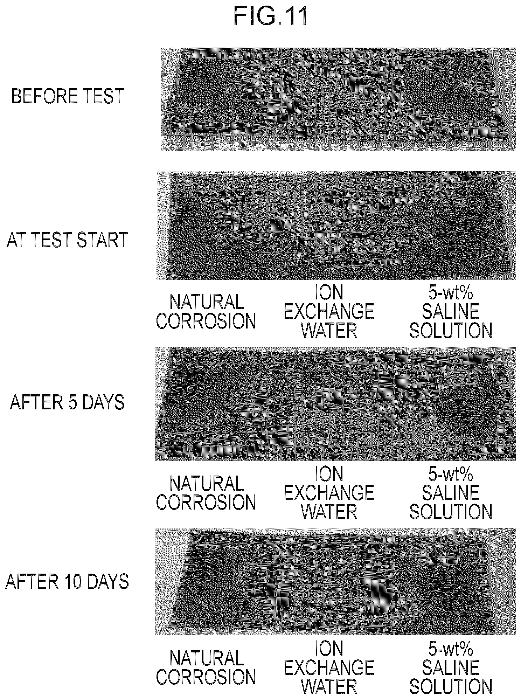

Fig. 10A is a surface photograph of each test sample before natural corrosion, the dripping of ion exchange water, and the dripping of 5-wt% saline solution, Fig. 10B is a surface photograph of each test sample after natural corrosion, the dripping of ion exchange water, and the dripping of 5-wt% saline solution, and Fig. 10C is a surface photograph of each test sample when the dripped liquid was removed 1 hour after being dripped. Further, Fig. 11 is a continuation of the first corrosion accelerating test results shown in Figs. 10A to 10C. The first row shows the surface photographs of each test sample before natural corrosion, the dripping of ion exchange water, and the dripping of 5-wt% saline solution (same as Fig. 10A), the second row shows the surface photographs of each test sample after being rinsed and dried 1 hour after natural corrosion, the dripping of ion exchange water, and the dripping of 5-wt% saline solution (same as Fig. 10C), the third row shows the surface photographs of each test sample 5 days thereafter, and the fourth row shows the surface photographs of each test sample 5 days thereafter (for a total of 10 days).

From the results shown in Figs. 10A to 10C and Fig. 11, it was confirmed that, in a case in which the saline solution was dripped, the surface changed to black in color at the start of the test (after being rinsed and dried 1 hour after the dripping of 5-wt% saline solution), and gradually changed after 5 days and after 10 days. On the other hand, with the ion exchange water, even though the surface partially changed to brown in color, there were no significant changes in time series.

### [Experiment Example 8]

A second corrosion accelerating test was conducted. In this test, because no significant change was confirmed over time in the first corrosion accelerating test described above when rinsing was performed after the dripping of the saline solution, only wiping was performed after the dripping of the saline solution. The sample used was obtained by using a transparent polystyrene board having a thickness of 1 mm as the base material, providing electroless copper plating (Rochelle salt bath) thereon, and providing the same FeC alloy-coated layer as in Sample 2 thereon. The test was conducted in an environment having a room temperature of 25°C to 30°C and a humidity of 50% to 60%.

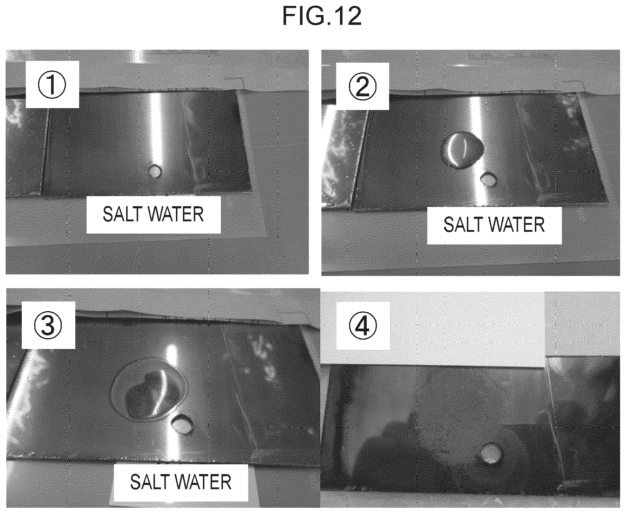

Fig. 12 shows the results of the second corrosion accelerating test of the iron-coated layer. Number 1 in the figure is a surface photograph of the test sample after the iron-coated layer was provided, number 2 is a surface photograph of the test sample when the 5-wt% saline solution was dripped, number 3 is a surface photograph of the test sample after the dripped saline solution was wiped off (without rinsing and drying), and number 4 is a surface photograph of the test sample 10 days thereafter.

As shown in Fig. 12, it was confirmed that large red rust was generated after 10 days, and the degree of rust change over time can be varied.

### [Summary]

As described in the above-described Experiment Examples 3 to 8, in the plastic model 20 according to the present invention, it was found that various states can be changed and changed states can be made to coexist. Specifically, it was found that, by making a portion where rust is generated on the iron-coated layer 2 and a portion where rust is not generated on the iron-coated layer 2 coexist to make different portions coexist, it is possible to change the state of the rust as desired for each portion of the plastic model 20.

Furthermore, by these experiment examples, it could be shown that a location in which the paint film 3 is provided on a portion where rust is generated on the iron-coated layer 2, a location in which the paint film 3 is not provided on a portion where rust is generated on the iron-coated layer 2, a location in which the paint film 3 is provided on a portion where rust is not generated on the iron-coated layer 2, and a location in which the paint film 3 is not provided on a portion where rust is not generated on the iron-coated layer 2 can be formed as desired. By making it possible to thus provide various portions as desired, the state of rust can be changed as desired for each portion of the plastic model 20, and portions where the progression of rust is stopped and portions where the progression of rust is varied in degree and continued can be made to coexist. As a result, each enthusiast can create an original model.

### Descriptions of Reference Numerals

- 1: Base material
- 2: Iron-coated layer
- 3: Paint film
- 4: Other layer (Base layer or base treatment layer)
- 10: Model component
- 20: Plastic model

## Claims

1. A plastic model (20) assembled by components (10), some or all components including a base material (1) and at least an iron-coated layer (2) provided on the base material, the plastic model comprising:
one or two or more areas selected from states of being provided with a paint film (3) on a portion where rust is generated on the iron-coated layer,
not being provided with a paint film on a portion where rust is generated on the iron-coated layer,
being provided with a paint film on a portion where rust is not generated on the iron-coated layer, and
not being provided with a paint film on a portion where rust is not generated on the iron-coated layer.

2. The plastic model according to claim 1, wherein
the iron-coated layer is provided directly on the base material,
the iron-coated layer is provided between the base material and the paint film,
the iron-coated layer is provided as an outermost surface layer on another layer provided as necessary on the base material,
the iron-coated layer is provided between another layer provided as necessary on the base material and the paint film, or
the paint film is provided between the base material and the iron-coated layer.

3. The plastic model according to claim 1 or 2, wherein
the iron-coated layer is a pure iron-coated layer or an iron alloy-coated layer.

4. The plastic model according to any one of claims 1 to 3, wherein
the iron-coated layer contains a dispersing material.

5. The plastic model according to any one of claims 1 to 4, wherein
the iron-coated layer is deposited by a wet deposition method, a PVD method, or a CVD method.

6. The plastic model according to any one of claims 1 to 5, wherein
a portion where rust is generated on the iron-coated layer and a portion where rust is not generated on the iron-coated layer coexist.

7. The plastic model according to claim 2, wherein
the other layer is a base treatment layer, a base layer, or a metal layer.

8. A plastic model component used as some or all components of the plastic model described in any one of claims 1 to 7, comprising:
a base material (1); and
at least an iron-coated layer (2) provided on the base material,
the plastic model component including one or two or more areas selected from states of
being provided with a paint film (3) on a portion where rust is generated on the iron-coated layer,
not being provided with a paint film on a portion where rust is generated on the iron-coated layer,
being provided with a paint film on a portion where rust is not generated on the iron-coated layer, and
not being provided with a paint film on a portion where rust is not generated on the iron-coated layer.

9. The plastic model component according to claim 8, wherein
the area is an area capable of changing over time by,
in a case in which the iron-coated layer is exposed on the surface, causing natural corrosion in the iron-coated layer or increasing rust by placement in an oxidation environment, or,
in a case in which the paint film is provided on the iron-coated layer, causing or increasing rust as in the real thing by a process of scraping off the paint film to expose the iron-coated layer or a process of scratching the paint film.

10. A method of manufacturing the plastic model described in any one of claims 1 to 7, comprising:
at least forming an iron-coated layer (2) on a prepared base material (1) to fabricate an iron-coated layer forming component; and,
as necessary, applying another treatment to the iron-coated layer forming component to fabricate a plastic model component,
the plastic model being assembled using the plastic model component thus fabricated as some or all components, and
the plastic model thus assembled including one or two or more areas selected from states of
being provided with a paint film (3) on a portion where rust is generated on the iron-coated layer,
not being provided with a paint film on a portion where rust is generated on the iron-coated layer,
being provided with a paint film on a portion where rust is not generated on the iron-coated layer, and
not being provided with a paint film on a portion where rust is not generated on the iron-coated layer.

11. A method of manufacturing some or all components of the plastic model described in any one of claims 1 to 7, the method comprising:
at least forming an iron-coated layer on a prepared base material,
the plastic model component thus manufactured including one or two or more areas selected from states of
being provided with a paint film on a portion where rust is generated on the iron-coated layer,
not being provided with a paint film on a portion where rust is generated on the iron-coated layer,
being provided with a paint film on a portion where rust is not generated on the iron-coated layer, and
not being provided with a paint film on a portion where rust is not generated on the iron-coated layer.

12. The method of manufacturing a plastic model component according to claim 11, wherein
the iron-coated layer is deposited by varying deposition conditions selected from a deposition time, a deposition temperature, a deposition composition, and the like.

13. The method of manufacturing a plastic model component according to claim 11 or 12, wherein
the iron-coated layer is provided on a treated base or on a base layer.

## Patentansprüche

1. Plastikmodell (20), aufgebaut aus Komponenten (10), wobei manche oder alle Komponenten ein Basismaterial (1) und zumindest eine Eisenbeschichtungsschicht (2) umfassen, die auf dem Basismaterial bereitgestellt ist, wobei das Plastikmodell Folgendes umfasst:
einen oder zwei oder mehrere Bereiche, ausgewählt aus folgenden Zuständen:
bereitgestellt mit einer Farbschicht (3) auf einem Abschnitt, auf dem Rost auf der Eisenbeschichtungsschicht entstanden ist,
nicht bereitgestellt mit einer Farbschicht auf einem Abschnitt, auf dem Rost auf der Eisenbeschichtungsschicht entstanden ist,
bereitgestellt mit einer Farbschicht auf einem Abschnitt, auf dem kein Rost auf der Eisenbeschichtungsschicht entstanden ist, und
nicht bereitgestellt mit einer Farbschicht auf einem Abschnitt, auf dem kein Rost auf der Eisenbeschichtungsschicht entstanden ist.

2. Plastikmodell nach Anspruch 1, wobei
die Eisenbeschichtungsschicht direkt auf dem Basismaterial bereitgestellt ist,
die Eisenbeschichtungsschicht zwischen dem Basismaterial und der Farbschicht bereitgestellt ist,
die Eisenbeschichtungsschicht als äußerste Oberflächenschicht auf einer weiteren Schicht, die als auf dem Basismaterial notwendig bereitgestellt ist, bereitgestellt ist,
die Eisenbeschichtungsschicht zwischen einer weiteren Schicht, die als auf dem Basismaterial und der Farbschicht notwendig bereitgestellt ist, bereitgestellt ist, oder
die Farbschicht zwischen dem Basismaterial und der Eisenbeschichtungsschicht bereitgestellt ist.

3. Plastikmodell nach Anspruch 1 oder 2, wobei die Eisenbeschichtungsschicht eine Rein-Eisenbeschichtungsschicht oder eine Eisenlegierungsbeschichtungsschicht ist.

4. Plastikmodell nach einem der Ansprüche 1 bis 3, wobei die Eisenbeschichtungsschicht ein Dispergiermaterial umfasst.

5. Plastikmodell nach einem der Ansprüche 1 bis 4, wobei die Eisenbeschichtungsschicht durch ein Nassabscheidungsverfahren, ein PVD-Verfahren oder ein CVD-Verfahren abgeschieden ist.

6. Plastikmodell nach einem der Ansprüche 1 bis 5, wobei ein Abschnitt, auf dem Rost auf der Eisenbeschichtungsschicht entstanden ist, und ein Abschnitt, auf dem kein Rost auf der Eisenbeschichtungsschicht entstanden ist, gleichzeitig vorliegen.

7. Plastikmodell nach Anspruch 2, wobei die weitere Schicht eine Basisbehandlungsschicht, eine Basisschicht oder eine Metallschicht ist.

8. Plastikmodellkomponente, die als manche oder alle der Komponenten des Plastikmodells, das in einem der Ansprüche 1 bis 7 beschrieben ist, verwendet wird, die Folgendes umfasst:
ein Basismaterial (1); und
zumindest eine Eisenbeschichtungsschicht (2), die auf dem Basismaterial bereitgestellt ist, wobei die Plastikmodellkomponente einen oder zwei oder mehr Bereiche umfasst, die aus den folgenden Zuständen ausgewählt sind:
bereitgestellt mit einer Farbschicht (3) auf einem Abschnitt, auf dem Rost auf der Eisenbeschichtungsschicht entstanden ist,
nicht bereitgestellt mit einer Farbschicht auf einem Abschnitt, auf dem Rost auf der Eisenbeschichtungsschicht entstanden ist,
bereitgestellt mit einer Farbschicht auf einem Abschnitt, auf dem kein Rost auf der Eisenbeschichtungsschicht entstanden ist, und
nicht bereitgestellt mit einer Farbschicht auf einem Abschnitt, auf dem kein Rost auf der Eisenbeschichtungsschicht entstanden ist.

9. Plastikmodellkomponente nach Anspruch 8, wobei der Bereich ein Bereich ist, der dazu in der Lage ist, sich über die Zeit zu ändern, indem
in einem Fall, in dem die Eisenbeschichtungsschicht auf der Oberfläche freigelegt ist, eine natürliche Korrosion in der Eisenbeschichtungsschicht oder vermehrter Rost durch Platzieren in einer Oxidationsumgebung bewirkt wird, oder in einem Fall, in dem die Farbschicht auf der Eisenbeschichtungsschicht bereitgestellt ist, Rost oder vermehrter Rost wie in der echten Komponente durch einen Vorgang des Abkratzens der Farbschicht zum Freilegen der Eisenbeschichtungsschicht oder einen Vorgang des Zerkratzens der Farbschicht bewirkt wird.

10. Verfahren zur Herstellung des Plastikmodells, das in einem der Ansprüche 1 bis 7 beschrieben ist, das Folgendes umfasst:
zumindest Ausbilden einer Eisenbeschichtungsschicht (2) auf einem vorbereiteten Basismaterial (1), um eine eine Eisenbeschichtungsschicht bildende Komponente herzustellen; und
falls notwendig, Aufbringen einer weiteren Behandlung auf die eine Eisenbeschichtungsschicht bildende Komponente, um eine Plastikmodellkomponente herzustellen,
wobei das Plastikmodell unter Verwendung der somit hergestellten Plastikmodellkomponente als manche oder alle der Komponenten aufgebaut wird, und
das so aufgebaute Plastikmodell einen oder zwei oder mehrere Bereiche umfasst, die aus folgenden Zuständen ausgewählt sind:
bereitgestellt mit einer Farbschicht (3) auf einem Abschnitt, auf dem Rost auf der Eisenbeschichtungsschicht entstanden ist,
nicht bereitgestellt mit einer Farbschicht auf einem Abschnitt, auf dem Rost auf der Eisenbeschichtungsschicht entstanden ist,
bereitgestellt mit einer Farbschicht auf einem Abschnitt, auf dem kein Rost auf der Eisenbeschichtungsschicht entstanden ist, und
nicht bereitgestellt mit einer Farbschicht auf einem Abschnitt, auf dem kein Rost auf der Eisenbeschichtungsschicht entstanden ist.

11. Verfahren zur Herstellung mancher oder aller der Komponenten des in einem der Ansprüche 1 bis 7 beschriebenen Plastikmodells, wobei das Verfahren Folgendes umfasst:
zumindest Ausbilden einer Eisenbeschichtungsschicht auf einem vorbereiteten Basismaterial,
wobei die so hergestellte Plastikmodellkomponente einen oder zwei oder mehr Bereiche umfasst, die aus folgenden Zuständen ausgewählt sind:
bereitgestellt mit einer Farbschicht auf einem Abschnitt, auf dem Rost auf der Eisenbeschichtungsschicht entstanden ist,
nicht bereitgestellt mit einer Farbschicht auf einem Abschnitt, auf dem Rost auf der Eisenbeschichtungsschicht entstanden ist,
bereitgestellt mit einer Farbschicht auf einem Abschnitt, auf dem kein Rost auf der Eisenbeschichtungsschicht entstanden ist, und
nicht bereitgestellt mit einer Farbschicht auf einem Abschnitt, auf dem kein Rost auf der Eisenbeschichtungsschicht entstanden ist.

12. Verfahren zur Herstellung einer Plastikmodellkomponente nach Anspruch 11, wobei die Eisenbeschichtungsschicht durch Variieren der Abscheidungsbedingungen, ausgewählt aus Abscheidungszeit, einer Abscheidungstemperatur, einer Abscheidungszusammensetzung und dergleichen, abgeschieden wird.

13. Verfahren zur Herstellung einer Plastikmodellkomponente nach Anspruch 11 oder 12, wobei die Eisenbeschichtungsschicht auf einer behandelten Basis oder auf einer Basisschicht bereitgestellt ist.

## Revendications

1. Modèle en plastique (20) assemblé par des composants (10), certains ou tous les composants incluant un matériau de base (1) et au moins une couche revêtue de fer (2) prévue sur le matériau de base, le modèle en plastique comprenant :
une ou deux ou plusieurs zones choisies parmi des états
étant pourvu d'un film de peinture (3) sur une partie où de la rouille est générée sur la couche revêtue de fer,
n'étant pas pourvu d'un film de peinture sur une partie où de la rouille est générée sur la couche revêtue de fer,
étant pourvu d'un film de peinture sur une partie où de la rouille n'est pas générée sur la couche revêtue de fer, et
n'étant pas pourvu d'un film de peinture sur une partie où de la rouille n'est pas générée sur la couche revêtue de fer.

2. Modèle en plastique selon la revendication 1, dans lequel
la couche revêtue de fer est fournie directement sur le matériau de base,
la couche revêtue de fer est fournie entre le matériau de base et le film de peinture,
la couche revêtue de fer est fournie sous la forme d'une couche de surface la plus externe sur une autre couche fournie si nécessaire sur le matériau de base,
la couche revêtue de fer est prévue entre une autre couche fournie si nécessaire sur le matériau de base et le film de peinture, ou
le film de peinture est fourni entre le matériau de base et la couche revêtue de fer.

3. Modèle en plastique selon la revendication 1 ou 2, dans lequel
la couche revêtue de fer est une couche revêtue de fer pur ou une couche revêtue d'alliage de fer.

4. Modèle en plastique selon l'une quelconque des revendications 1 à 3, dans lequel
la couche revêtue de fer contient un matériau dispersant.

5. Modèle en plastique selon l'une quelconque des revendications 1 à 4, dans lequel
la couche revêtue de fer est déposée par un procédé de dépôt par voie humide, un procédé PVD ou un procédé CVD.

6. Modèle en plastique selon l'une quelconque des revendications 1 à 5, dans lequel
une partie où de la rouille est générée sur la couche revêtue de fer et une partie où de la rouille n'est pas générée sur la couche revêtue de fer coexistent.

7. Modèle en plastique selon la revendication 2, dans lequel
l'autre couche est une couche de traitement de base, une couche de base ou une couche métallique.

8. Composant de modèle en plastique utilisé en tant que tout ou partie des composants du modèle en plastique décrit selon l'une quelconque des revendications 1 à 7, comprenant :
un matériau de base (1) ; et
au moins une couche revêtue de fer (2) fournie sur le matériau de base,
le composant de modèle en plastique incluant une ou deux zones ou plus choisies parmi des états
étant pourvu d'un film de peinture (3) sur une partie où de la rouille est générée sur la couche revêtue de fer,
n'étant pas pourvu d'un film de peinture sur une partie où de la rouille est générée sur la couche revêtue de fer,
étant pourvu d'un film de peinture sur une partie où de la rouille n'est pas générée sur la couche revêtue de fer, et
n'étant pas pourvu d'un film de peinture sur une partie où de la rouille n'est pas générée sur la couche revêtue de fer.

9. Composant de modèle en plastique selon la revendication 8, dans lequel
la zone est une zone capable de changer au fil du temps,
dans le cas où la couche revêtue de fer est exposée sur la surface, en provoquant une corrosion naturelle dans la couche revêtue de fer ou en augmentant la rouille par mise en place dans un environnement d'oxydation, ou,
dans un cas où le film de peinture est fourni sur la couche revêtue de fer, en provoquant ou en augmentant la rouille comme dans la réalité par un processus de raclage du film de peinture pour exposer la couche revêtue de fer ou un processus de grattage du film de peinture.

10. Procédé de fabrication d'un modèle en plastique décrit dans l'une quelconque des revendications 1 à 7, comprenant les étapes consistant à :
former au moins une couche revêtue de fer (2) sur un matériau de base préparé (1) pour fabriquer un composant de formation de couche revêtue de fer ; et,
si nécessaire, appliquer un autre traitement au composant de formation de couche revêtue de fer pour fabriquer un composant de modèle en plastique,
le modèle en plastique étant assemblé en utilisant le composant de modèle en plastique ainsi fabriqué en tant que certains ou tous les composants, et
le modèle en plastique ainsi assemblé incluant une ou deux zones ou plus choisies parmi des états
étant pourvu d'un film de peinture (3) sur une partie où de la rouille est générée sur la couche revêtue de fer,
n'étant pas pourvu d'un film de peinture sur une partie où de la rouille est générée sur la couche revêtue de fer,
étant pourvu d'un film de peinture sur une partie où de la rouille n'est pas générée sur la couche revêtue de fer, et
n'étant pas pourvu d'un film de peinture sur une partie où de la rouille n'est pas générée sur la couche revêtue de fer.

11. Procédé de fabrication d'un modèle en plastique décrit selon l'une quelconque des revendications 1 à 7, le procédé comprenant les étapes consistant à :
former au moins une couche revêtue de fer sur un matériau de base préparé,
le composant de modèle en plastique ainsi fabriqué incluant une ou deux zones ou plus choisies parmi les états
étant pourvu d'un film de peinture sur une partie où de la rouille est générée sur la couche revêtue de fer,
n'étant pas pourvu d'un film de peinture sur une partie où de la rouille est générée sur la couche revêtue de fer,
étant pourvu d'un film de peinture sur une partie où de la rouille n'est pas générée sur la couche revêtue de fer, et
n'étant pas pourvu d'un film de peinture sur une partie où de la rouille n'est pas générée sur la couche revêtue de fer.

12. Procédé de fabrication d'un modèle en plastique selon la revendication 11, dans lequel
la couche revêtue de fer est déposée en faisant varier les conditions de dépôt choisies parmi un temps de dépôt, une température de dépôt, une composition de dépôt, et analogues.

13. Procédé de fabrication d'un modèle en plastique selon la revendication 11 ou 12, dans lequel
la couche revêtue de fer est fournie sur une base traitée ou sur une couche de base.
